(19) **Europäisches Patentamt European Patent Office Office européen des brevets**

(11) **EP 2 192 571 B1**

(12) **EUROPEAN PATENT SPECIFICATION**

(45) Date of publication and mention of the grant of the patent:
**23.08.2017 Bulletin 2017/34**

(51) Int Cl.:
**G09G 3/32** *(2016.01)*

(21) Application number: **09176250.0**

(22) Date of filing: **17.11.2009**

(54) **Organic light emitting display device and method of driving the same**

Organische lichtemittierende Anzeigevorrichtung und Antriebsverfahren dafür

Dispositif à affichage électroluminescent organique et son procédé de commande

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **26.11.2008 KR 20080118055**

(43) Date of publication of application:
**02.06.2010 Bulletin 2010/22**

(73) Proprietor: **Samsung Display Co., Ltd. Gyeonggi-do (KR)**

(72) Inventors:
• **Kang, Chul-Kyu**
  **Gyeonggi-do (KR)**
• **Choi, Sang-Moo**
  **Gyeonggi-do (KR)**
• **Kim, Keum-Nam**
  **Gyeonggi-do (KR)**

(74) Representative: **Walaski, Jan Filip**
**Venner Shipley LLP**
**200 Aldersgate**
**London EC1A 4HD (GB)**

(56) References cited:
**WO-A1-2005/036515       WO-A1-2008/075697**
**CA-A1- 2 557 713       US-A1- 2004 026 723**
**US-A1- 2007 126 665**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention relates to an organic light emitting display device and a method of driving the same.

Recently, various types of flat panel display devices having reduced weight and volume in comparison to cathode ray tubes have been developed. Flat panel display devices include liquid crystal display devices, field emission display devices, plasma display panels, and organic light emitting display devices, among others.

Among these flat panel display devices, the organic light emitting display device displays images using organic light emitting diodes that emit light through the recombination of electrons and holes. The organic light emitting display device has a fast response time and is driven with low power consumption.

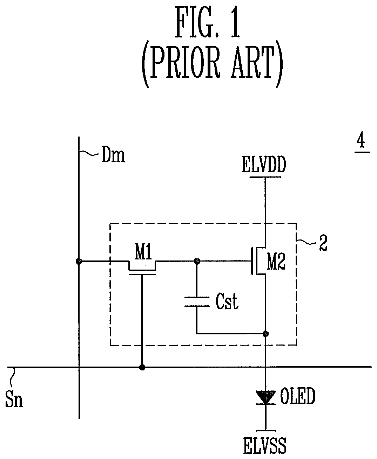

FIG. 1 is a circuit diagram of a conventional pixel of an organic light emitting display device. In FIG. 1, transistors included in the pixel are NMOS transistors.

Referring to FIG. 1, the conventional pixel 4 of the organic light emitting display device includes an organic light emitting diode OLED and a pixel circuit 2 connected to a data line Dm and a scan line Sn to control the organic light emitting diode OLED.

An anode electrode of the organic light emitting diode OLED is coupled to the pixel circuit 2, and a cathode electrode thereof is coupled to a second power source ELVSS. The organic light emitting diode OLED emits light having luminance corresponding to current supplied from the pixel circuit 2.

The pixel circuit 2 controls an amount of current supplied to the organic light emitting diode OLED corresponding to a data signal supplied to a data line Dm when a scan signal is supplied to a scan line Sn. To this end, the pixel circuit 2 includes a second transistor M2 (i.e., a driving transistor) coupled between a first power source ELVDD and the organic light emitting diode OLED; a first transistor M1 coupled between the second transistor M2 and the data line Dm, with a gate electrode coupled to the scan line Sn; and a storage capacitor Cst coupled between a gate electrode and a second electrode of the second transistor M2.

A gate electrode of the first transistor M1 is coupled to the scan line Sn, and a first electrode thereof is coupled to the data line Dm. A second electrode of the first transistor M1 is coupled to one terminal of the storage capacitor Cst. Here, the first electrode is either a source or a drain electrode, and the second electrode is the other electrode different from the first electrode. For example, if the first electrode is a drain electrode, the second electrode is a source electrode. When a scan signal is supplied to the first transistor M1 from the scan line Sn, the first transistor M1 is turned on, and a data signal supplied from the data line Dm is supplied to the storage capacitor Cst. At this time, a voltage corresponding to the data signal is charged into the storage capacitor Cst.

The gate electrode of the second transistor M2 is coupled to the one terminal of the storage capacitor Cst, and a first electrode thereof is coupled to the first power source ELVDD. The second electrode of the second transistor M2 is coupled to the other terminal of the storage capacitor Cst and the anode electrode of the organic light emitting diode OLED. The second transistor M2 controls an amount of current flowing from the first power source ELVDD through the organic light emitting diode OLED to the second power source ELVSS, the amount of current corresponding to the voltage stored in the storage capacitor Cst.

One terminal of the storage capacitor Cst is coupled to the gate electrode of the second transistor M2, and the other terminal thereof is coupled to the anode electrode of the organic light emitting diode OLED. A voltage corresponding to a data signal is charged into the storage capacitor Cst.

The conventional pixel 4 displays an image having a predetermined luminance by supplying current to the organic light emitting diode OLED corresponding to the voltage charged in the storage capacitor Cst. However, in such a conventional organic light emitting display device, images having uniform luminance are very difficult to display due to the threshold voltage variation of the second transistor M2.

Threshold voltages of second transistors M2 in respective pixels 4 are different from each other, and the respective pixels 4 generate light having different luminance in response to a same data signal. Therefore, images having uniform luminance cannot be displayed.

WO 2008/075697 A1 discloses a light emitting display device which suppresses the effects of characteristic variations of a driving transistor and a characteristic shift caused by electrical stress.

US 2007/126665 A1 discloses a display device which includes a pixel formed using a current-drive display element whose luminance changes in accordance with signals and a semiconductor having a function to control current supplied to a load with a transistor.

CA 2 557 713 A1 discloses a method and system for compensating luminance degradation in electro-luminance devices.

US 2004/026723 A1 discloses an electronic circuit and method capable of reducing dispersion in the threshold voltages of driving transistors for obtaining a desired image display quality.

WO 2005/036515 A1 discloses an active matrix electroluminescent display with means for interrupting the drive of current through a pixel, thereby enabling a scrolling row-by-row addressing scheme for the pixels to be implemented.

Accordingly, exemplary embodiments of the present invention provide an organic light emitting display device which may compensate for a threshold voltage of a driving transistor and a method of driving the same. The invention is set forth in claims 1 and 4. According to the present invention, there is provided an organic light emitting display device according to claim 1.

An aspect of an exemplary embodiment of the present invention provides an organic light emitting display device including: a scan driver for sequentially supplying a scan signal through scan lines; a data driver for supplying an initial voltage through data lines during a first period of a time period when the scan signal is supplied through a corresponding scan line of the scan lines, and for supplying data signals to the data lines during a second period of the time period when the scan signal is supplied through the corresponding scan line, the second period following the first period; and pixels at crossing regions of the scan lines and the data lines, wherein a pixel coupled to an i-th ("i" is a natural number) scan line of the scan lines and a j-th ("j" is a natural number) data line of the data lines from among the pixels includes: an organic light emitting diode having a cathode electrode coupled to a second power source; a first transistor for controlling current flowing through the organic light emitting diode; a second transistor coupled to the j-th data line and a second node, the second transistor being on when the scan signal is supplied through the i-th scan line; a third transistor coupled between a first node coupled to a gate electrode of the first transistor and the second node, the third transistor being off when the second transistor is on; a fourth transistor coupled between the first node and a reference voltage source, the fourth transistor being on when the scan signal is supplied through the i-th scan line; and a first capacitor coupled between the second node and an anode electrode of the organic light emitting diode.

A voltage of the data signals may be equal to or higher than a voltage of the reference voltage source. The initial voltage may be higher than a voltage of the data signal. The organic light emitting display device may further include a second capacitor coupled in parallel with the third transistor between the first node and the second node.

An aspect of another exemplary embodiment of the present invention provides a method of driving an organic light emitting display device, including: supplying a reference power to a gate electrode of the driving transistor when a scan signal is supplied; supplying an initial power to a second terminal of the first capacitor through a data line during a first period of a time period when the scan signal is supplied; supplying a data signal to the second terminal of the first capacitor through the data line during a second period of the time period when the scan signal is supplied, the second period following the first period, wherein a voltage at the anode electrode of the organic light emitting diode is obtained by subtracting a threshold voltage of the driving transistor from the reference power; and supplying current to the organic light emitting diode by coupling the gate electrode of the driving transistor to the second terminal of the first capacitor.

An aspect of yet another exemplary embodiment of the present invention provides a pixel of an organic light emitting display device coupled to a scan line for supplying a scan signal and a data line for supplying a data signal, including: an organic light emitting diode coupled to a second power source; a first transistor coupled between the organic light emitting diode and a first power source, the first transistor for controlling current flowing through the organic light emitting diode in accordance with the data signal; a second transistor coupled to the data line for supplying the data signal when the scan signal is supplied; a third transistor coupled between the second transistor and a gate electrode of the first transistor; a fourth transistor coupled between the gate electrode of the first transistor and a reference voltage source; and a first capacitor coupled between the second transistor and the organic light emitting diode; wherein the second transistor and the fourth transistor concurrently turn on and off, and wherein the third transistor is turned off when the second transistor and the fourth transistor are turned on.

In an organic light emitting display device and a method of driving the same, a desired current may be supplied to an organic light emitting diode regardless of a threshold voltage of a driving transistor. Accordingly, an image having uniform luminance may be displayed.

The accompanying drawings illustrate exemplary embodiments of the present invention, and, together with the description, serve to explain the principles of the present invention.

FIG. 1 is a circuit diagram of a pixel of a conventional organic light emitting display device.
FIG. 2 is a schematic block diagram of an organic light emitting display device according to an embodiment of the present invention.
FIG. 3 is a circuit diagram of a pixel according to a first embodiment of the present invention.
FIG. 4 is a waveform diagram illustrating a method of driving the pixel shown in FIG. 3.
FIG. 5 is a graph showing current of an organic light emitting diode, corresponding to a change in voltage of a data signal in the pixel shown in FIG. 3.
FIG. 6 is a circuit diagram of a pixel according to an example not forming part of the present invention.
FIG. 7 is a waveform diagram illustrating a method of driving the pixel shown in FIG. 6.
FIG. 8 is a circuit diagram showing a structure in which transistors are converted into PMOS transistors in the pixel shown in FIG. 3.

Hereinafter, certain exemplary embodiments according to the present invention will be described with reference to the accompanying drawings. Here, when a first element is described as being coupled to a second element, the first element may be directly coupled to the second element, or may be indirectly coupled to the second element via one or more additional elements. Further, some of the elements that are not essential to the complete understanding of the invention are omitted for clarity. Also, like reference numerals refer to like elements throughout.

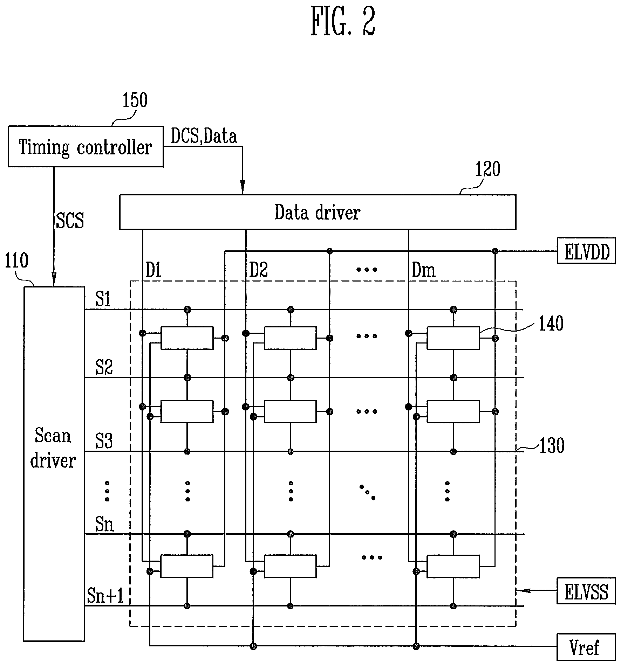

FIG. 2 is a schematic block diagram of an organic light emitting display device according to an embodiment of the present invention.

Referring to FIG. 2, the organic light emitting display device according to the embodiment of the present invention includes pixels 140 coupled to scan lines S1 to Sn+1 and data lines D1 to Dm; a scan driver 110 driving the scan lines S1 to Sn+1; a data driver 120 driving the data lines D1 to Dm; and a timing controller 150 controlling the scan and data drivers 110 and 120.

The scan driver 110 receives a scan driving control signal SCS from the timing controller 150. The scan driver 110 generates a scan signal and sequentially supplies the generated scan signal to the scan lines S1 to Sn+1.

The data driver 120 receives a data driving control signal DCS supplied from the timing controller 150. The data driver 120 supplies an initial voltage to the data lines D1 to Dm during a first period of a time period when a scan signal (e.g., a high scan signal) is supplied, and supplies a data signal to the data lines D1 to Dm during a second period after the first period. Here, the initial voltage is set higher than that of the data signal.

The timing controller 150 generates a data driving control signal DCS and a scan driving control signal SCS in response to synchronization signals supplied from the outside. The data driving control signal DCS generated from the timing controller 150 is supplied to the data driver 120, and the scan driving control signal SCS generated from the timing controller 150 is supplied to the scan driver 110. The timing controller 150 also supplies data Data supplied from the outside to the data driver 120.

A display unit 130 receives a first power source ELVDD, a second power source ELVSS and a reference voltage source Vref supplied from the outside, and supplies them to each of the pixels 140. Each of the pixels 140 receiving the first power source ELVDD, the second power source ELVSS and the reference voltage source Vref generates light in response to the data signals.

Here, the voltage of the first power source ELVDD is set higher than that of the second power source ELVSS so that a current (e.g., a predetermined current) is supplied to the organic light emitting diodes. A voltage of the reference voltage source Vref is set equal to or lower than that of the data signal.

Meanwhile, a pixel 140 positioned in an i-th ("i" is a natural number) horizontal line is coupled to an i-th scan line and an (i+1)-th scan line, as well as a j-th ("j" is a natural number) data line. The pixel 140 includes a plurality of transistors, which may be NMOS transistors, and supplies a current which is compensated for the threshold voltage of a driving transistor to a corresponding organic light emitting diode. In other embodiments, some or all of the plurality of transistors may be PMOS transistors.

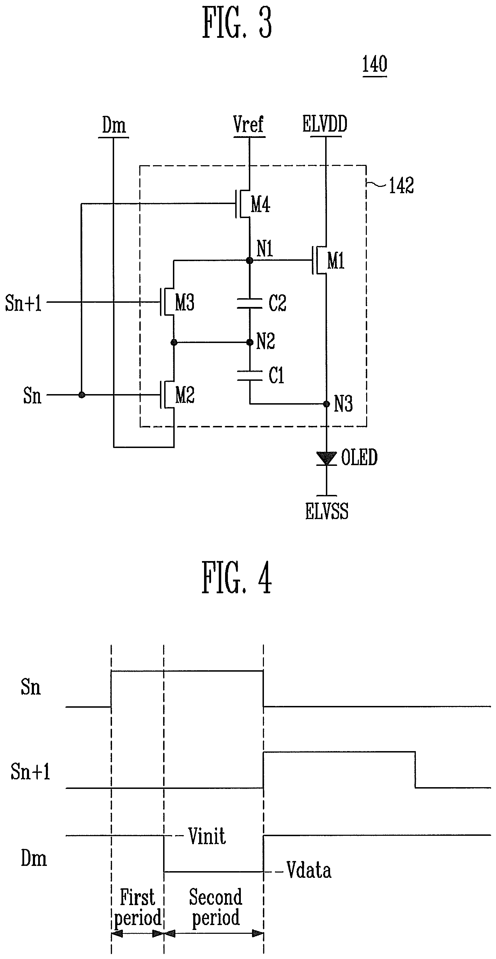

FIG. 3 is a circuit diagram of a pixel according to a first embodiment of the present invention. For convenience of illustration, FIG. 3 shows a pixel positioned on an n-th horizontal line and coupled to an m-th data line Dm.

Referring to FIG. 3, the pixel 140 according to the first embodiment of the present invention includes an organic light emitting diode OLED and a pixel circuit 142 coupled to the data line Dm and the scan lines Sn and Sn+1 to control the organic light emitting diode OLED.

An anode electrode of the organic light emitting diode OLED is coupled to the pixel circuit 142, and a cathode electrode thereof is coupled to a second power source ELVSS. The organic light emitting diode OLED generates light having a luminance (e.g., a predetermined luminance) corresponding to current supplied from the pixel circuit 142.

When a scan signal is supplied through the n-th scan line Sn, the pixel circuit 142 supplies a voltage corresponding to a data signal supplied through the data line Dm and a threshold voltage of a first transistor M1 to be charged in a first capacitor C1. When a scan signal is supplied through the (n+1)-th scan line Sn+1, the pixel circuit 142 supplies current corresponding to the charged voltage to the organic light emitting diode OLED. To this end, the pixel circuit 142 includes first to fourth transistors M1 to M4, and first and second capacitors C1 and C2.

A gate electrode of the first transistor M1 is coupled to a first node N1, and a first electrode thereof is coupled to a first power source ELVDD. A second electrode of the first transistor M1 is coupled to an anode electrode of the organic light emitting diode OLED at a third node N3.

A gate electrode of the second transistor M2 is coupled to the n-th scan line Sn, and a first electrode thereof is coupled to the data line Dm. A second electrode of the second transistor M2 is coupled to a second node N2. When a scan signal is supplied through the n-th scan line Sn, the second transistor M2 is turned on to allow the data line Dm to be electrically coupled to the second node N2.

A gate electrode of the third transistor M3 is coupled to the (n+1)-th scan line Sn+1, and a first electrode thereof is coupled to the second node N2. A second electrode of the third transistor M3 is coupled to the first node N1 (i.e., the gate electrode of the first transistor M1). When a scan signal is supplied through the (n+1)-th scan line Sn+1, the third transistor M3 is turned on to allow the first node N1 to be electrically coupled to the second node N2. The third transistor M3 is in a turned-off state while the second transistor M2 is turned on.

A gate electrode of the fourth transistor M4 is coupled to the n-th scan line Sn, and a first electrode thereof is coupled to a reference voltage source Vref. A second electrode of the fourth transistor M4 is coupled to the first node N1. When a scan signal is supplied through the n-th scan line Sn, the fourth transistor M4 is turned on to supply the voltage of the reference voltage source Vref to the first node N1.

The first and second capacitors C1 and C2 are coupled in series between the first and third nodes N1 and N3. A common node of the first and second capacitors C1 and C2 is coupled to a common node (i.e., the second node N2) of the second and third transistors M2 and M3. Here, the second capacitor C2 and the third transistor M3 are coupled in parallel between the first and second node N1 and N2.

FIG. 4 is a waveform diagram illustrating a method of driving the pixel shown in FIG. 3.

Operations of the pixel will be described in detail in conjunction with FIGS. 3 and 4. First, a scan signal (e.g., a high scan signal) is supplied through the n-th scan line Sn, and an initial voltage Vinit is supplied through the data line Dm during a first period of a time period when the scan signal is supplied through the n-th scan line Sn.

When the scan signal is supplied through the n-th scan line Sn, the second and fourth transistors M2 and M4 are turned on. When the second transistor M2 is turned on, the initial voltage Vinit is supplied to the second node N2. When the fourth transistor M4 is turned on, the voltage of the reference voltage source Vref is supplied to the first node N1. Here, the voltage of the reference voltage source Vref is set as a low voltage at which the first transistor M1 is turned off.

Thereafter, a data signal is supplied through the data line Dm during a second period after the first period, and accordingly the voltage at the second node N2 is dropped to the voltage of the data signal. When the voltage at the second node N2 is dropped, the voltage at the third node N3 is also dropped due to coupling of the first capacitor C1. At this time, the first transistor M1 is turned on, and the voltage at the third node N3 is raised to a voltage obtained by subtracting the threshold voltage of the first transistor M1 from the voltage of the reference voltage source Vref. To this end, when the data signal is supplied through the data line Dm, the initial voltage Vinit is set to allow the voltage at the third node N3 to be dropped to a lower voltage than that of the reference voltage source Vref.

At this time, a voltage of Vdata-Vref is charged in the second capacitor C2, and a voltage of Vdata-Vref+Vth is charged in the first capacitor C1. Here, Vdata refers to a voltage of the data signal.

Thereafter, the supply of the scan signal through the n-th scan line Sn is stopped (e.g., the scan signal turns low), and the second and fourth transistors M2 and M4 are turned off. A scan signal (e.g., the high scan signal) is supplied through the (n+1)-th scan line Sn+1, and the first node N1 is electrically coupled to the second node N2. In this case, the voltage applied between the terminals of the second capacitor C2 is set as 0V, and the voltage between the gate and source electrodes of the first transistor M1 is set as a voltage charged into the first capacitor C1. That is, the voltage of the first transistor M1 is set based on Equation 1:

Equation 1

$$Vgs(M1) = Vdata-Vref+Vth(M1) \qquad \ldots\ldots(1)$$

An amount of current flowing through the organic light emitting diode OLED is set using the voltage Vgs of the first transistor M1 based on Equation 2:

Equation 2

$$Ioled \quad = \beta(Vgs(M1)-Vth(M1))^2 = \beta\{(Vdata-Vref+Vth(M1))-Vth(M1)\}^2$$
$$= \beta(Vdata-Vref)^2 \qquad \ldots\ldots(2)$$

Referring to Equation 2, the current flowing through the organic light emitting diode OLED is determined by a voltage difference between the voltage Vdata of the data signal and the reference voltage source Vref. Here, since the reference voltage source Vref is a fixed voltage, the current flowing through the organic light emitting diode OLED is determined by the data signal.

Meanwhile, a voltage range of the first power source ELVDD, the reference voltage source Vref and the voltage Vdata of the data signal is set based on Equation 3:

Equation 3

$$ELVDD > Vdata \geq Vref \qquad \ldots\ldots(3)$$

The voltage of the reference voltage Vref is a fixed voltage having a low voltage at which current does not flow through the organic light emitting diode OLED, and Vdata is changed corresponding to a gray level expressed as the voltage of the data signal. Here, a gray level is realized by the voltage Vdata of the data signal and the voltage of the reference voltage source. Therefore, the voltage Vdata of the data signal is set equal to or higher than that of the reference voltage source Vref.

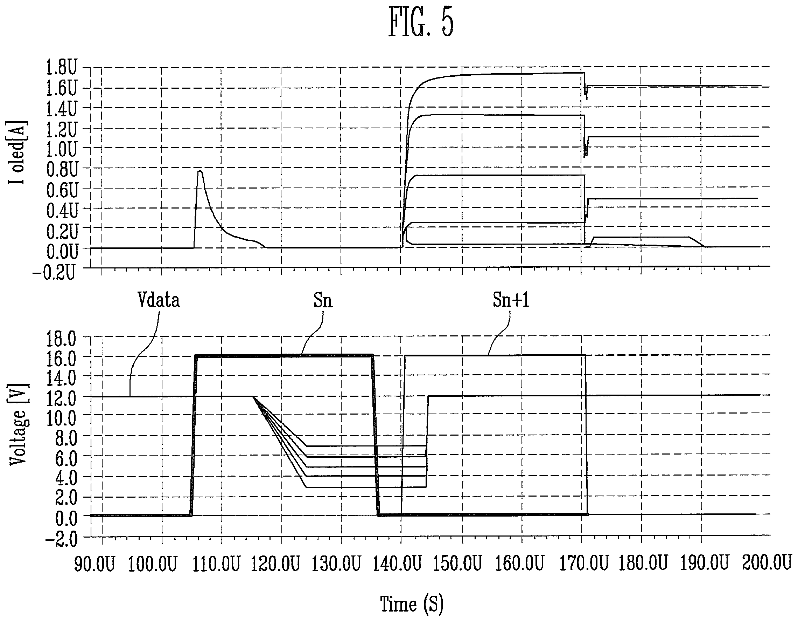

FIG. 5 is a graph showing current flowing through an organic light emitting diode, corresponding to a voltage of a data signal.

Referring to FIG. 5, the current flowing through the organic light emitting diode OLED is changed depending on a change in voltage Vdata of the data signal. That is, in the present invention, an amount of current flowing through the organic light emitting diode OLED is changed corresponding to a change in voltage of the data signal. Accordingly, a desired gray level can be expressed.

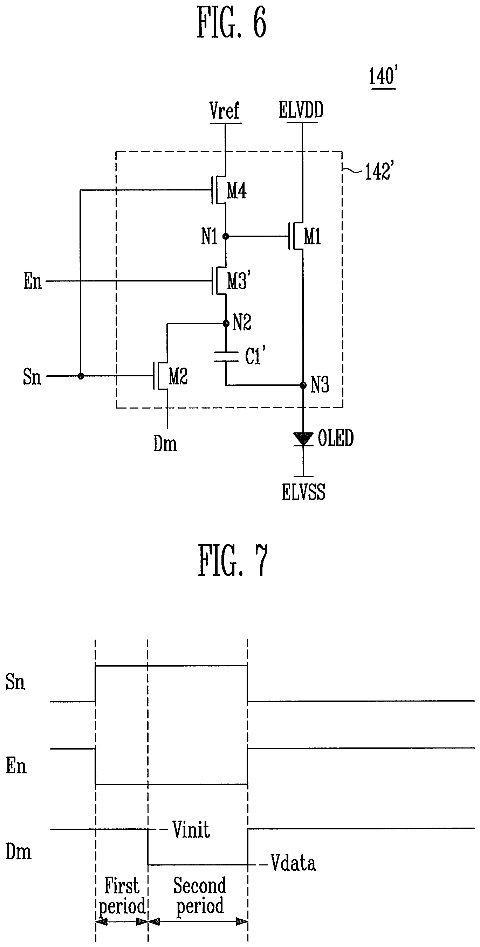

FIG. 6 is a circuit diagram of a pixel according to an example not forming part of the present invention. In FIG. 6, elements identical to those of FIG. 3 are provided with the same reference numerals, and their detailed descriptions will be omitted.

Referring to FIG. 6, the pixel 140' according to the second embodiment of the present invention is coupled to a light emission control line En. Here, light emission control lines E1 to En are positioned parallel with scan lines S1 to Sn and formed in respective horizontal lines. That is, the light emission control lines E1 to En are arranged parallel with the scan lines S1 to Sn. A light emission control signal supplied through an i-th ("i" is a natural number) light emission control line Ei is supplied to overlap with a scan signal supplied through an i-th scan line Si.

Meanwhile, the scan signal sequentially supplied through the scan lines S1 to Sn may be set as a voltage (e.g., a high level voltage) at which transistors may be turned on, and the light emission control signal sequentially supplied through the light emission control lines E1 to En may be set as a voltage (e.g., a low level voltage) at which the transistors may be turned off.

A gate electrode of a third transistor M3' included in the pixel circuit 142' is coupled to the light emission control line En, and a first electrode of the third transistor M3' is coupled to a second node N2. A second electrode of the third transistor M3' is coupled to a first node N1.

A first capacitor C1' is coupled between the first electrode of the third transistor M3' (i.e., the second node N2) and a third node N3.

When comparing the pixel 140' witch the pixel 140 shown in FIG. 3, the electric connection of the third transistor M3' and the first capacitor C1' is set different from that in the pixel 140. When comparing the pixel 140' witch the pixel 140 shown in FIG. 3, the second capacitor C2 has been removed in the pixel 140'.

FIG. 7 is a waveform diagram illustrating a method of driving the pixel shown in FIG. 6, which does not form part of the present invention.

Operations of the pixel will be described in detail in conjunction with FIGS. 6 and 7. First, a scan signal (e.g., a high scan signal) is supplied through the n-th scan line Sn, and an initial voltage Vint is supplied through a data line Dm during a first period of a time period when the scan signal is supplied through the n-th scan line Sn. A light emission control signal (e.g., a low light emission control signal) is supplied through the n-th light emission control line En during the period when the scan signal is supplied through the n-th scan line Sn.

When the light emission control signal is supplied through the n-th light emission control line En, the third transistor M3' is turned off. When the scan signal is supplied through the n-th scan line Sn, second and fourth transistors M2 and M4 are turned on. When the second transistor M2 is turned on, the initial voltage Vint supplied from the data line Dm is supplied to the second node N2. When the fourth transistor M4 is turned on, the voltage of a reference voltage Vref is supplied to the first node N1.

Thereafter, a data signal is supplied through the data line Dm during a second period after the first period, and accordingly, the voltage at the second node N2 is dropped to the voltage Vdata of the data signal. When the voltage at the second node N2 is dropped, the voltage at the third node N3 is also dropped due to coupling of the first capacitor C1'. At this time, the first transistor M1 is turned on, and the voltage at the third node N3 is raised to a voltage obtained by subtracting the threshold voltage of the first transistor M1 from the voltage of the reference voltage source Vref. Here, a voltage set based on Equation 1 is charged into the first capacitor C1'.

Thereafter, the supply of the scan signal through the n-th scan line Sn is stopped (e.g., the scan signal is turned low), and the second and fourth transistors M2 and M4 are turned off. The supply of the light emission control signal through the n-th light emission control line En is also stopped (e.g., the light emission control signal is turned high), and the third transistor M3' is turned on. When the third transistor M3' is turned on, the second node N2 is electrically coupled to the first node N1. Accordingly, the first transistor M1 supplies current corresponding to the voltage charged into the first capacitor C1' to an organic light emitting diode OLED. A current set based on Equation 2 is therefore supplied to the organic light emitting diode OLED. That is, in the pixel 140' according to the second embodiment of the present invention, a desired current may be supplied to the organic light emitting diode OLED regardless of the threshold voltage of the first transistor M1.

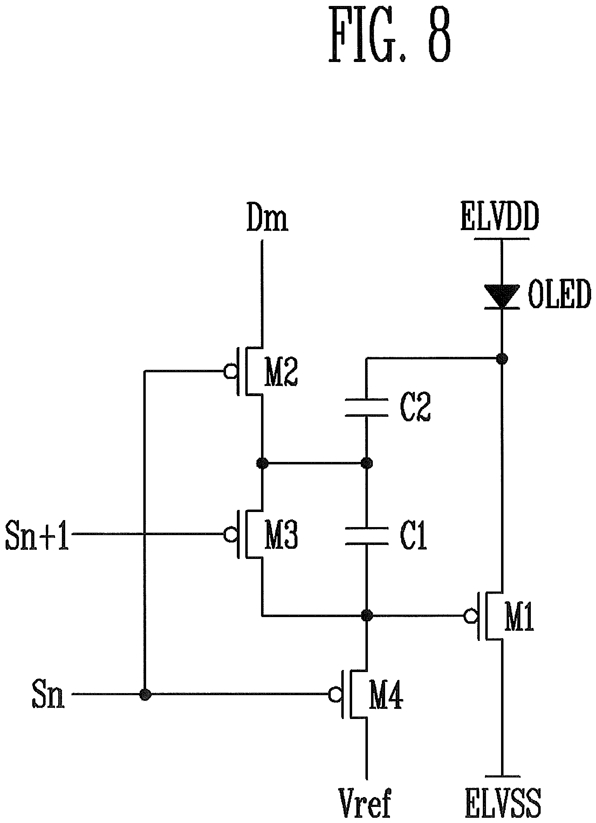

Meanwhile, it has been described in FIGS. 3 and 6 that the transistors are NMOS transistors. However, the present invention is not limited thereto. For example, the transistors of the pixel shown in FIG. 3 may instead be PMOS transistors, as shown in, for example, FIG. 8. In this case, operations are substantially similar, except that the polarities of the waveforms shown in FIG. 4 are reversed.

While the present invention has been described in connection with certain exemplary embodiments, it is to be understood that the invention is not limited to the disclosed embodiments, but is instead intended to cover various modifications and equivalent arrangements included within the scope of the appended claims.

**Claims**

1. An organic light emitting display device comprising:

   a scan driver (110) for sequentially supplying a scan signal through scan lines;
   a data driver (120) for supplying an initial voltage (Vinit) through data lines during a first period when the scan signal is supplied through a corresponding one of the scan lines, and for supplying data signals to the data lines during a second period when the scan signal is supplied through the corresponding scan line, the second period following the first period; and
   pixels (140, 140') at crossing regions of the scan lines and the data lines,
   wherein a pixel coupled to an i-th ("i" is a natural number) scan line and a j-th ("j" is a natural number) data line comprises:

   an organic light emitting diode having a first electrode coupled to a power source;
   a first transistor (M1) for controlling current flowing through the organic light emitting diode;
   a second transistor (M2) coupled to the j-th data line and a second node (N2), wherein a gate electrode of the second transistor (M2) is coupled to the i-th scan line, a first electrode of the second transistor (M2) is coupled to the j-th data line and a second electrode of the second transistor (M2) is coupled to the second node (N2);
   a third transistor (M3) coupled between a first node (N1) that is coupled to a gate electrode of the first transistor (M1) and the second node (N2), wherein a gate electrode of the third transistor (M3) is coupled to an (i+1)-th scan line, a first electrode of the third transistor (M3) is coupled to the second node (N2) and a second electrode of the third transistor (M3) is coupled to the first node (N1);
   a fourth transistor (M4) coupled between the first node (N1) and a reference voltage source (Vref), wherein a gate electrode of the fourth transistor (M4) is coupled to the i-th scan line;
   a first capacitor (C1, C2) coupled between the second node (N2) and a second electrode (N3) of the organic light emitting diode; and
   a second capacitor (C2, C1) coupled in parallel with the third transistor (M3) between the first node and the second node.

2. The organic light emitting display device of claim 1, wherein a voltage of the data signals is equal to or higher than a voltage of the reference voltage source.

3. The organic light emitting display device of claim 1 or 2, wherein the initial voltage (Vinit) is higher than a voltage of the data signals.

4. A method of driving an organic light emitting display device according to any one of the preceding claims, the method comprising:

   supplying a reference voltage to the gate electrode of the first transistor when a scan signal is supplied;
   supplying an initial voltage to the second terminal of the first capacitor through a data line during a first period when the scan signal is supplied;
   supplying a data signal to the second terminal of the first capacitor through the data line during a second period when the scan signal is supplied, the second period following the first period, wherein a voltage at the electrode of the organic light emitting diode is obtained by subtracting a threshold voltage of the first transistor from the reference voltage; and
   supplying current to the organic light emitting diode by coupling the gate electrode of the first transistor to the second terminal of the first capacitor.

5. The method of claim 4, wherein a voltage of the data signal is equal to or higher than the reference voltage of the reference power.

**6.** The method of claim 4 or 5, wherein the initial voltage is higher than a voltage of the data signal.

**Patentansprüche**

**1.** Organische lichtemittierende Anzeigevorrichtung, umfassend:

einen Abtasttreiber (110) zum sequenziellen Bereitstellen eines Abtastsignals über Abtastleitungen;
einen Datentreiber (120) zum Bereitstellen einer Anfangsspannung (Vinit) über Datenleitungen während eines ersten Zeitraums, in dem das Abtastsignal über eine entsprechende eine der Abtastleitungen bereitgestellt wird, und zum Bereitstellen von Datensignalen an die Datenleitungen während eines zweiten Zeitraums, in dem das Abtastsignal über die entsprechende Datenleitung bereitgestellt wird, wobei der zweite Zeitraum auf den ersten Zeitraum folgt; und
Pixel (140, 140') an sich kreuzenden Bereichen der Abtastleitungen und der Datenlinien,
wobei ein Pixel, der mit einer i-ten ("i" ist eine natürliche Zahl) Abtastleitung und einer j-ten ("j" ist eine natürliche Zahl) Datenleitung gekoppelt ist, Folgendes umfasst:

eine organische lichtemittierende Diode, die eine erste Elektrode aufweist, die mit einer Stromquelle verbunden ist;
einen ersten Transistor (M1) zum Steuern eines Stroms, der durch die organische lichtemittierende Diode fließt;
einen zweiten Transistor (M2), der mit der j-ten Datenleitung und einem zweiten Knoten (N2) verbunden ist, wobei eine Gate-Elektrode des zweiten Transistors (M2) mit der i-ten Abtastleitung verbunden ist, eine erste Elektrode des zweiten Transistors (M2) mit der j-ten Datenleitung verbunden ist und eine zweite Elektrode des zweiten Transistors (M2) mit dem zweiten Knoten (N2) verbunden ist;
einen dritten Transistor (M3), der zwischen einem ersten Knoten (N1), der mit einer Gate-Elektrode des ersten Transistors (M1) verbunden ist, und dem zweiten Knoten (N2) verbunden ist, wobei eine Gate-Elektrode des dritten Transistors (M3) mit der (i+1)-ten Abtastleitung verbunden ist, eine erste Elektrode des dritten Transistors (M3) mit dem zweiten Knoten (N2) verbunden ist und eine zweite Elektrode des dritten Transistors (M3) mit dem ersten Knoten (N1) verbunden ist;
einen vierten Transistor (M4), der zwischen dem ersten Knoten (N1) und einer Referenzspannungsquelle (Vref) verbunden ist, wobei eine Gate-Elektrode des vierten Transistors (M4) mit der i-ten Abtastleitung verbunden ist;
einen ersten Kondensator (C1, C2), der zwischen dem zweiten Knoten (N2) und einer zweiten Elektrode (N3) der organischen lichtemittierenden Diode verbunden ist; und
einen zweiten Kondensator (C2, C1), der parallel zu dem dritten Transistor (M3) zwischen dem ersten Knoten und dem zweiten Knoten verbunden ist.

**2.** Organische lichtemittierende Anzeigevorrichtung nach Anspruch 1, wobei eine Spannung des Datensignals gleich oder höher als eine Spannung der Referenzspannungsquelle ist.

**3.** Organische lichtemittierende Anzeigevorrichtung nach Anspruch 1 oder 2, wobei die Anfangsspannung (Vinit) höher als eine Spannung der Datensignale ist.

**4.** Verfahren zum Ansteuern einer organischen lichtemittierenden Anzeigevorrichtung nach einem der vorhergehenden Ansprüche, wobei das Verfahren Folgendes umfasst:

Bereitstellen einer Referenzspannung für die Gate-Elektrode des ersten Transistors, wenn ein Abtastsignal bereitgestellt wird;
Bereitstellen einer Anfangsspannung für den zweiten Anschluss des ersten Kondensators über eine Datenleitung während des ersten Zeitraums, wenn das Abtastsignal bereitgestellt wird;
Bereitstellen eines Datensignals für den zweiten Anschluss des ersten Kondensators über die Datenleitung während eines zweiten Zeitraums, wenn das Abtastsignal bereitgestellt wird, wobei der zweite Zeitraum auf den ersten Zeitraum folgt, wobei eine Spannung an der Elektrode der organischen lichtemittierenden Diode durch Subtrahieren einer Schwellenspannung des ersten Transistors von der Referenzspannung erhalten wird; und
Bereitstellen eines Stroms für die organische lichtemittierende Diode durch Verbinden der Gate-Elektrode des ersten Transistors mit dem zweiten Anschluss des ersten Kondensators.

**5.** Verfahren nach Anspruch 4, wobei eine Spannung des Datensignals gleich oder höher als die Referenzspannung des Referenzstroms ist.

**6.** Verfahren nach Anspruch 4 oder 5, wobei die Anfangsspannung höher als eine Spannung des Datensignals ist.

**Revendications**

**1.** Dispositif d'affichage électroluminescent organique comprenant :

un pilote de balayage (110) pour fournir séquentiellement un signal de balayage à travers des lignes de balayage ;
un pilote de données (120) pour fournir une tension initiale (Vinit) à travers des lignes de données pendant une première période lorsque le signal de balayage est fourni à travers une ligne de balayage correspondante parmi les lignes de balayage, et pour fournir des signaux de données aux lignes de données pendant une deuxième période lorsque le signal de balayage est fourni à travers la ligne de balayage correspondante, la deuxième période suivant la première période ; et
des pixels (140, 140') au niveau de régions de croisement des lignes de balayage et des lignes de données, où un pixel couplé à une i-ième ("i" est un nombre naturel) ligne de balayage et à une j-ième ("j" est un nombre naturel) ligne de données comprend :

une diode électroluminescente organique ayant une première électrode couplée à une source d'alimentation ;
un premier transistor ($M_1$) pour réguler le courant circulant à travers la diode électroluminescente organique ;
un deuxième transistor ($M_2$) couplé à la j-ième ligne de données et à un deuxième noeud ($N_2$), où une électrode de grille du deuxième transistor ($M_2$) est couplée à la i-ième ligne de balayage, une première électrode du deuxième transistor ($M_2$) est couplée à la j-ième ligne de données et une deuxième électrode du deuxième transistor ($M_2$) est couplée au deuxième noeud ($N_2$) ;
un troisième transistor ($M_3$) couplé entre un premier noeud ($N_1$) qui est couplé à une électrode de grille du premier transistor ($M_1$) et le deuxième noeud ($N_2$), où une électrode de grille du troisième transistor ($M_3$) est couplée à une (i+1)-ième ligne de balayage, une première électrode du troisième transistor ($M_3$) est couplée au deuxième noeud ($N_2$) et une deuxième électrode du troisième transistor ($M_3$) est couplée au premier noeud ($N_1$) ;
un quatrième transistor ($M_4$) couplé entre le premier noeud ($N_1$) et une source de tension de référence (Vref), où une électrode de grille du quatrième transistor ($M_4$) est couplée à la i-ième ligne de balayage ;
un premier condensateur ($C_1$, $C_2$) couplé entre le deuxième noeud ($N_2$) et une deuxième électrode ($N_3$) de la diode électroluminescente organique ; et
un deuxième condensateur ($C_2$, $C_1$) couplé en parallèle avec le troisième transistor ($M_3$) entre le premier noeud et le deuxième noeud.

**2.** Dispositif d'affichage électroluminescent organique de la revendication 1, dans lequel une tension des signaux de données est supérieure ou égale à une tension de la source de tension de référence.

**3.** Dispositif d'affichage électroluminescent organique de la revendication 1 ou 2, dans lequel la tension initiale (Vinit) est supérieure à une tension des signaux de données.

**4.** Procédé de pilotage d'un dispositif d'affichage électroluminescent organique selon l'une quelconque des revendications précédentes, le procédé comprenant le fait :

de fournir une tension de référence à l'électrode de grille du premier transistor lorsqu'un signal de balayage est fourni ;
de fournir une tension initiale à la deuxième borne du premier condensateur à travers une ligne de données pendant une première période lorsque le signal de balayage est fourni ;
de fournir un signal de données à la deuxième borne du premier condensateur à travers la ligne de données pendant une deuxième période lorsque le signal de balayage est fourni, la deuxième période suivant la première période, où une tension au niveau de l'électrode de la diode électroluminescente organique est obtenue en soustrayant une tension seuil du premier transistor de la tension de référence ; et
de fournir du courant à la diode électroluminescente organique en couplant l'électrode de grille du premier transistor à la deuxième borne du premier condensateur.

**5.** Procédé de la revendication 4, dans lequel une tension du signal de données est supérieure ou égale à la tension de référence de la puissance de référence.

**6.** Procédé de la revendication 4 ou 5, dans lequel la tension initiale est supérieure à une tension du signal de données.

# FIG. 1
# (PRIOR ART)

# FIG. 2

# FIG. 3

<u>140</u>

# FIG. 4

## FIG. 5

# FIG. 6

140'

Vref   ELVDD

~142'

M4

N1   M1

En   M3'

N2

C1'

Sn   M2   N3

Dm

OLED

ELVSS

# FIG. 7

Sn

En

Dm   — Vinit

— Vdata

First period | Second period

# FIG. 8

**REFERENCES CITED IN THE DESCRIPTION**

**Patent documents cited in the description**

- WO 2008075697 A1
- US 2007126665 A1
- CA 2557713 A1
- US 2004026723 A1
- WO 2005036515 A1